# EUROPEAN PATENT SPECIFICATION

(11) **EP 1 762 637 B1**
(45) Date of publication and mention of the grant of the patent: **21.01.2009**
(21) Application number: 06018198.9
(22) Date of filing: 31.08.2006
(51) Int. Cl.: C23C 30/00

(54) **PVD Coated cutting tool**
PVD beschichtetes Schneidwerkzeug
Outil de coupe revêtu par PVD

(30) Priority: 09.09.2005 SE 0502001
(43) Date of publication of application: 14.03.2007
(73) Proprietor: Sandvik Intellectual Property AB, 811 81 Sandviken (SE)
(72) Inventor: Schier, Veit, 70771 Echteringen (DE)
(74) Representative: Taquist, Henrik Lennart Emanuel

(56) References cited:
- EP-A- 1 347 076
- EP-A2- 1 103 635
- WO-A-01/16388
- WO-A-02/42515
- US-A1- 2002 028 323

## Description

The present invention relates to a cutting tool with improved properties for metal machining having a substrate of cemented carbide and a hard and wear resistant coating on the surface of said substrate. The coating is deposited by Physical Vapor Deposition (PVD). The coating is composed of metal nitrides in combination with alumina (Al₂O₃). The coating is composed of a laminar multilayered structure. In order to optimise the performance the insert is further treated to have different outer layers on the rake face and flank face respectively.

Modern high productivity tools for chip forming machining of metals requires reliable tools with excellent wear properties. Since the end of 1960s it is known that tool life can be significantly improved by applying a suitable coating to the surface of the tool. The first coatings for wear applications were made by Chemical Vapour Deposition (CVD) and this coating technique is still widely used for cutting tool applications. Physical Vapour Deposition (PVD) was introduced in the mid 1980s and has since then been further developed from single layers of stable metallic compounds like TiN or Ti(C,N) to include multicomponent and multilayer coatings also including metastable compounds like (Ti,Al)N or non metallic compounds like Al₂O₃.

RF-sputtering of alumina on cemented carbide cutting tools using deposition temperatures up to 900°C is described in Shinzato et.al, Thin Sol. Films, 97 (1982) 333-337. The use of PVD coatings of alumina for wear protection is described in Knotek et al, Surf. Coat. Techn., 59 (1993) 14-20*,* where the alumina is deposited as an outermost layer on a wear resistant carbonitride layer. The alumina layer is said to minimize adhesion wear and acts as a barrier to chemical wear. USP 5,879,823.discloses a tool material coated with PVD alumina as one or two out of a layer stack, the non-oxide layers being e.g. TiAl containing. The tool may have an outer layer of TiN. The Al₂O₃ may be of alpha, kappa, theta, gamma or amorphous type. Alumina coated tools where the oxide polymorph is of gamma type with a 400 or 440 texture are disclosed in USP 6,210,726. USP 5,310,607 discloses PVD deposited alumina with a content of >5% Cr. A hardness of >20GPa and a crystal structure of alpha phase is found for Cr contents above 20%. No Cr addition gives amorphous alumina with a hardness of 5 GPa.

Most coated tools to-day have a top layer of a goldish TiN to make it easy to differentiate between a used and an unused cutting edge by the naked eye. TiN is not always the preferred top layer especially not in applications where the chip may adhere to the TiN layer. Partial blasting of coatings is disclosed in EP-A-1193328 with the purpose to enable wear detection at the same time as the beneficial properties of the underlying coating are retained. Wear on the rake face is mostly chemical in nature and requires a chemically stable compound whereas wear on the flank face is mostly mechanical in nature and requires a harder and abrasive resistant compound.

It is an object of the present invention is to provide an improved cutting tool composition with a multilayer coating.

It is a further object of the present invention to further improve the performance of PVD coated cutting tools using the concept of different outer layers on the rake and flank face respectively.

The coating, made in process by PVD, comprises a (Ti,Al)N-compound next to the substrate, an alumina layer on top of the (Ti,Al)N-layer and at least two further alternating layers of (Ti,Al)N and alumina and an outermost layer of ZrN. The ZrN layer is removed on the rake face in a post treatment, preferably blasting or brushing. For complete removal of the ZrN layer on the rake face several repeated brushings or blastings are often necessary. An incomplete removal often results in local welding of the ZrN residuals to the chip which reduces tool life. In order to reduce the adherence of the top ZrN layer, an intermediate layer of substoichiometric ZrN₁₋ₓ is deposited on the alumina layer, underneath the ZrN layer. The substoichiometric ZrN₁₋ₓ has a reduced strength and facilitates the removal of the top ZrN layer.

According to the present invention there is now provided a cutting tool insert, having an upper face (rake face), an opposite face and at least one clearance face intersecting said upper and opposite faces to define cutting edges, comprising a cemented carbide substrate and a hard layer system. The cemented carbide has a composition of 86-90 weight% WC, 1-2 weight% (Ta,Nb)C and 8-13 weight% Co, preferably 88-89 weight% WC, 1,2-1,8 weight% (Ta,Nb)C and 10-11 weight% Co. The hard layer system has a total thickness of 3-30 µm, and comprises
- a first layer of (Ti,Al)N with a thickness of 1-5, preferably 2-4, µm,
- an alumina layer, preferably γ-alumina, with a thickness of 1-4, preferably 1-2 µm,
- a ((Ti,Al)N + alumina)*N multilayer, where N≥2, with a thickness of 0.1-0,3 µm,
- preferably a thin, preferably <0,1 µm, layer of substoichiometric ZrN₁₋ₓ, preferably x=0,01-0,1 and
- a ZrN layer with a thickness of 0,1-0,6 µm, the ZrN-layer missing on the rake face and on the edge line
wherein the (Ti,Al)N-layers preferably have an atomic composition of 60/40<Al/Ti<70/30, most preferably Al/Ti=67/33.

The present invention also relates to a method of making a coated cutting tool insert, having an upper face (rake face), an opposite face and at least one clearance face intersecting said upper and opposite faces to define cutting edges, comprising the following steps:
- providing a cemented carbide substrate with a composition of 86-90 weight% WC, 1-2 weight% (Ta,Nb)C and 8-13 weight% Co, preferably 88-89 weight% WC, 1,2-1,8 weight% (Ta,Nb)C and 10-11 weight% Co
- depositing onto the cemented carbide substrate, using PVD methods, a hard layer system with a total thickness of 3-30 µm, and comprising
   - a first layer of (Ti,Al)N with a thickness of 1-5, preferably 2-4 µm,
   - an alumina layer, preferably γ-alumina, with a thickness of 1-4, preferably 1-2 µm,
   - a ((Ti,Al)N + alumina)*N multilayer, where N≥2, with a thickness of 0.1-0,3 µm,
   - preferably a thin, preferably <0,1 µm, layer of substoichiometric ZrN₁₋ₓ, preferably x=0,01-0,1 and
   - an outermost ZrN layer with a thickness of 0,1-0,6 µm wherein the (Ti,Al)N-layers preferably have an atomic composition of 60/40<Al/Ti<70/30, most preferably Al/Ti=67/33 and
- removing said ZrN-layer on the rake face and on the edge line by a post-treatment, preferably by brushing or blasting.

### Example 1

The versions A to C represent relevant background art that is useful for understanding the invention.

Cemented carbide inserts ADMT 160608R with the composition 88 weight% WC, 1,5 weight% (Ta,Nb)C and 10,5 weight% Co were coated with PVD-technique according to the following sequences in one process
Version A; a layer stack (Ti_{0.33}Al_{0.67}N-Al₂O₃Ti_{0.33}Al_{0.67}N-Al₂O₃-Ti_{0.33}Al_{0.67}N- Al₂O₃),
Version B; a layer stack (Ti_{0.33}Al_{0.67}N-Al₂O₃)
Version C; a Ti_{0.33}Al_{0.67}N layer.

The inserts were tested in a dry shoulder milling application.

Work piece material: Martensitic stainless steel X90CrMoV18 (1.4112).

Cutting speed: 140 m/min

Tool life criteria: Number of produced parts

**Table 1 Tool life parts produced after edge milling**

| Coating | Ti_{0.33}Al_{0.67}N | Ti_{0.33}Al_{0.67}N-Al₂O₃ | 3x(Ti_{0.33}Al_{0.67}N-Al₂O₃) |
|---|---|---|---|
| Tool life parts | 3 | 4 | 7 |

The result shows the effect of an increasing layer thickness on tool life in edge milling.

### Example 2

Cemented carbide inserts ADMT 160608R with the composition 88 weight% WC, 1,5 weight% (Ta,Nb)C and 10,5 weight% Co were coated with PVD-technique according to the following sequence in one process: 3 µm (Ti,Al)N (Al/Ti 67/33 %), 1,5 µm nanocrystalline γ-alumina, 0,2 µm (Ti,Al)N (Al/Ti 67/33 %), 0,2 µm nanocrystalline γ-alumina, 0,1 µm (Ti,Al)N (Al/Ti 67/33 %), 0,1 µm nanocrystalline γ-alumina, 0,1-0,5 µm ZrN.

The top layer of ZrN was blasted off on the rake face using alumina in a wet blasting process.

Both blasted and unblasted inserts were used to edge mill a Ti-alloy (toughness 1400 N/mm²).

The maximum flank wear was measured after a cutting distance of 890 mm with the following result.

**Table 2. Wear (mm) after edge milling**

| | Untreated | ZrN removed on rake face |
|---|---|---|
| Maximum flank wear | 0,40-0,45 | 0,15-0,23 |
| Maximum radius wear | 0,23-0,3 | 0,10-0,13 |

It is clearly shown that the removal of ZrN on the top rake face leads to a considerably lower wear.

## Claims

1. A PVD coated cemented carbide insert having an upper face (rake face), an opposite face and at least one clearance face intersecting said upper and opposite faces to define cutting edges where the cemented carbide having a composition of 86-90 weight% WC, 1-2 weight% (Ta,Nb)C and 8-13 weight% Co, preferably 88-89 weight% WC, 1,2-1,8 weight% (Ta,Nb)C and 10-11 weight% Co **characterised in**
- being coated with a hard layer system, having a total thickness of 3-30 µm, comprising
- a first layer of (Ti,Al)N with a thickness of 1-5, preferably 2-4, µm,
- an alumina layer, preferably γ-alumina, with a thickness of 1-4, preferably 1-2; µm,
- a ((Ti,Al)N + alumina)*N multilayer, where N≥2, with a thickness of 0,1-0,3 µm and
- a ZrN layer with a thickness of 0,1-0,6 µm, the ZrN-layer missing on the rake face and on the edge line
wherein the (Ti,Al)N-layers preferably have an atomic composition of 60/40<Al/Ti<70/30, most preferably A1/Ti=67/33.

2. A cutting tool insert according to claim 1
**characterised in** a thin, preferably <0,1 µm, layer of substoichiometric ZrN₁₋ₓ, preferably x=0,01-0,1 underneath the top layer of ZrN.

3. Method of making a coated cutting tool insert, having an upper face (rake face), an opposite face and at least one clearance face intersecting said upper and opposite faces to define cutting edges, by providing a cemented carbide substrate with a composition of 86-90 weight% WC, 1-2 weight% (Ta,Nb)C and 8-13 weight% Co, preferably 88-89 weight% Wc, 1,2-1,8 weight% (Ta,Nb)C and 10-11 weight% Co and
**characterised in** comprising the following steps
- depositing onto the cemented carbide substrate, using PVD methods, a hard layer system using PVD-methods, with a total thickness of 3-30 µm, and comprising
- a first layer of (Ti,Al)N with a thickness of 1-5, preferably 2-4 µm,
- an alumina layer, preferably γ-alumina, with a thickness of 1-4, preferably 1-2 µm,
- a ((Ti,Al)N + alumina)*N multilayer, where N≥2, with a thickness of 0,1-0,3 µm, and
- an outermost ZrN layer with a thickness 0,1-0,6 µm wherein the (Ti,Al)N-layers preferably have an atomic composition of 60/40<A1/Ti<70/30, most preferably Al/Ti=67/33 and
- removing said ZrN-layer on the rake face and on the edge line by a post-treatment, preferably by brushing or blasting.

4. Method according to claim 3 **characterised in** depositing a thin, preferably <0,1 µm, layer of substoichiometric ZrN₁₋ₓ, preferably x=0,01-0,1 on top of the ((Ti,Al)N + alumina)*N multilayer.

## Patentansprüche

1. PVD-beschichteter Hartmetalleinsatz mit einer oberen Fläche (Spanfläche), einer gegenüberliegenden Fläche und wenigstens einer Freifläche, welche die obere und die gegenüberliegende Fläche schneidet und **dadurch** Schneidkanten definiert, wobei das Hartmetall eine Zusammensetzung von 86-90 Gewichts-% WC, 1-2 Gewichts-% (Ta,Nb)C und 8-13 Gewichts-% Co, bevorzugt von 88-89 Gewichts-% WC, 1,2-1,8 Gewichts-% (Ta,Nb)C und 10-11 Gewichts-% Co, hat, **dadurch gekennzeichnet, daß**
- der Einsatz mit einem System aus harten Lagen beschichtet ist, welches eine Gesamtdikke von 3-30 um hat und folgendes umfaßt:
- eine erste Lage aus (Ti,Al)N mit einer Dicke von 1-5, bevorzugt von 2-4, µm,
- eine Aluminiumoxidlage, bevorzugt aus γ-Aluminiumoxid, mit einer Dicke von 1-4, bevorzugt von 1-2, µm,
- eine ((Ti,Al)N + Aluminiumoxid)*N-Multilage, wobei N ≥ 2 ist, mit einer Dicke von 0,1-0,3 µm und
- eine ZrN-Lage mit einer Dicke von 0,1-0,6 µm, wobei die ZrN-Lage auf der Spanfläche und der Kantenlinie fehlt,
wobei die (Ti,Al)N-Lagen vorzugsweise eine atomare Zusammensetzung von 60/40 < Al/Ti < 70/30, am meisten bevorzugt von Al/Ti = 67/33, haben.

2. Schneidwerkzeugeinsatz nach Anspruch 1, **dadurch gekennzeichnet, daß** eine dünne, vorzugsweise < 0,1 µm dicke, Lage aus substöchiometrischem ZrN₁₋ₓ, wobei bevorzugt x = 0,01-0,1 ist, unterhalb der oberen Lage aus ZrN vorliegt.

3. Verfahren zur Herstellung eines Schneidwerkzeugeinsatzes mit einer oberen Fläche (Spanfläche), einer gegenüberliegenden Fläche und wenigstens einer Freifläche, welche die obere und die gegenüberliegende Fläche schneidet und **dadurch** Schneidkanten definiert, bei dem man ein Hartmetallsubstrat mit einer Zusammensetzung von 86-90 Gewichts-% WC, 1-2 Gewichts-% (Ta,Nb)C und 8-13 Gewichts-% Co, bevorzugt von 88-89 Gewichts-% WC, 1,2-1,8 Gewichts-% (Ta,Nb)C und 10-11 Gewichts-% Co, bereitstellt, und wobei das Verfahren **dadurch gekennzeichnet ist, daß** es die folgenden Stufen umfaßt:
- Abscheiden eines Systems aus harten Lagen auf dem Hartmetallsubstrat unter Verwendung von PVD-Verfahren, wobei das System eine Gesamtdicke von 3-30 µm hat und folgendes umfaßt:
- eine erste Lage aus (Ti,Al)N mit einer Dicke von 1-5, bevorzugt von 2-4, µm,
- eine Aluminiumoxidlage, bevorzugt aus γ-Aluminiumoxid, mit einer Dicke von 1-4, bevorzugt von 1-2, µm,
- eine ((Ti,Al)N + Aluminiumoxid)*N-Multilage, wobei N ≥ 2 ist, mit einer Dicke von 0,1-0,3 µm und
- eine äußerste ZrN-Lage mit einer Dicke von 0,1-0,6 µm, wobei die (Ti,Al)N-Lagen bevorzugt eine atomare Zusammensetzung von 60/40 < Al/Ti < 70/30, am meisten bevorzugt von Al/Ti = 67/33, haben, und
- Entfernen der ZrN-Lage auf der Spanfläche und der Kantenlinie durch eine Nachbehandlung, bevorzugt mittels Bürsten oder Abstrahlen.

4. Verfahren nach Anspruch 3, **dadurch gekennzeichnet, daß** man eine dünne, vorzugsweise < 0,1 µm dicke, Lage aus substöchiometrischem ZrN₁₋ₓ, wobei bevorzugt x = 0,01-0,1 ist, auf der ((Ti,Al)N + Aluminiumoxid)*N-Multilage abscheidet.

## Revendications

1. Plaquette en carbure cémenté revêtue par dépôt physique en phase vapeur, ayant une face supérieure (face de coupe), une face opposée et au moins une face de dégagement sécante avec lesdites faces supérieure et opposée pour définir des arêtes de coupe, le carbure cémenté ayant une composition de 86-90% en poids de WC, 1-2 % en poids (Ta, Nb) C et 8-13 % en poids Co, de préférence 88-89% en poids de WC, 1,2-1,8 % en poids (Ta, Nb) C et 10-11 % en poids Co, **caractérisée en ce que** :
- il est revêtu avec un système de couche dure, ayant une épaisseur totale de 3-30 µm, comprenant :
- une première couche de (Ti, Al) N d'épaisseur 1-5, de préférence 2-4 µm,
- une couche d'alumine, de préférence γ-alumine, d'épaisseur 1-4, de préférence 1-2 µm,
- une multi-couche de ((Ti, Al) N + alumine)*N, où N≥2, d'épaisseur 0,1-0,3 µm et
- une couche de ZrN d'épaisseur 0,1-0,6 µm, la couche de ZrN manquant sur la face de coupe et sur la ligne d'arête,
les couches de (Ti, Al) N ayant de préférence une composition atomique de 60/40<Al/Ti<70/30, de façon plus préférée Al/Ti = 67/33.

2. Plaquette d'outil de coupe selon la revendication 1, **caractérisée par** une couche mince, de préférence <0,1 µm, de ZrN₁₋ₓ substoechiométrique, de préférence x = 0,01-0,1, sous la couche du haut de ZrN.

3. Procédé de fabrication d'une plaquette d'outil de coupe revêtue, ayant une face supérieure (face de coupe), une face opposée et au moins une face de dégagement sécante avec lesdites faces supérieure et opposée pour définir des arêtes de coupe, en fournissant un substrat en carbure cémenté avec une composition de 86-90%pds de WC, 1-2 % en poids (Ta, Nb) C et 8-13 % en poids Co, de préférence 88-89% en poids de WC, 1,2-1,8 % en poids (Ta, Nb) C et 10-11 % en poids Co et **caractérisé en ce qu'**il comprend les étapes suivantes :
- déposer sur le substrat en carbure cémenté, en utilisant des procédés de dépôt physique en phase vapeur, un système de couche dure en utilisant des procédés de dépôt physique en phase vapeur, avec une épaisseur totale de 3-30 µm, et comprenant :
- une première couche de (Ti, Al) N d'épaisseur 1-5, de préférence 2-4 µm,
- une couche d'alumine, de préférence y-alumine, d'épaisseur 1-4, de préférence 1-2 µm,
- une multi-couche de ((Ti, Al) N + alumine)*N, où N≥2, d'épaisseur 0,1-0,3 µm, et
- une couche extérieure de ZrN d'épaisseur 0,1-0,6 µm, les couches de (Ti, Al) N ayant de préférence une composition atomique de 60/40<Al/Ti<70/30, de façon plus préférée Al/Ti = 67/33 et
- enlever ladite couche de ZrN sur la face de coupe et sur la ligne d'arête par un post-traitement, de préférence par brossage ou abrasion.

4. Procédé selon la revendication 3, **caractérisé par** le dépôt d'une couche mince, de préférence <0,1 µm, de ZrN₁₋ₓ substoechiométrique, de préférence x = 0,01-0,1, sous le haut de la multi-couche de ((Ti, Al) N + oxyde d'aluminium)*N.
